# EUROPEAN PATENT APPLICATION

(11) **EP 3 648 142 A1**
(43) Date of publication of application: **06.05.2020**
(21) Application number: 19205801.4
(22) Date of filing: 29.10.2019
(51) Int. Cl.: H01J 49/02

(54) **FREQUENCY SWITCHING METHOD APPLICABLE TO MASS SPECTROMETER MULTIPOLE RF DRIVE SYSTEMS**

(30) Priority: 31.10.2018 US 201816176115
(71) Applicant: Agilent Technologies, Inc. (A Delaware Corporation), Santa Clara, CA 95051 (US)
(72) Inventor: Schoessow, Michael J., Santa Clara, California 95051-7201 (US)
(74) Representative: Zimmermann, Tankred Klaus

(57) **Abstract**

In one embodiment, a system includes a mass analyzer, an ion source for providing ions to the mass analyzer, a detector for detecting an output of the mass analyzer, and a frequency-selectable power source. The frequency-selectable power source may include an energy supply configured to provide high-voltage radio-frequency (RF) energy to the mass analyzer at individually selectable first and second frequencies, and a frequency selector for switching between the individually selectable first and second frequencies.

## Description

### TECHNICAL FIELD

The present disclosure relates generally to radio-frequency power generation for mass spectrometers.

### BACKGROUND

Many mass spectrometers require a source of high-voltage radio-frequency energy to apply to a multi-rod assembly in a vacuum manifold. This voltage source drives a substantially capacitive load consisting of a multi-polar rod assembly. Constancy is required in both the amplitude and the frequency once a given level and frequency are set.

A precise source of very high voltage radio-frequency sine waves is required. The choice of operating frequency in a mass spectrometer involves trade-offs; a higher frequency yields higher mass resolution while a lower frequency yields better sensitivity for a given RF power level. Spectrometers have generally been designed to operate at a single frequency, chosen as a compromise between resolution, sensitivity, and RF power requirements.

For a given instrument running a particular experiment, the desired frequency is normally fixed. The amplitude, however, must be settable over a wide range, such as 50V to 10kVpp (as one example).

There are two basic LC topologies that are used to accomplish the voltage step-up. They are sometimes referred to as the parallel resonant approach and the series resonant approach. Generally, an oscillator is used to drive a radio-frequency power amplifier, which in turn drives a high-Q LC resonator tuned to the same frequency as the oscillator. The resonator greatly magnifies the drive voltage from the power amplifier.

A disadvantage of the resonantor approach is that a given LC resonant circuit only works to step up the RF voltage efficiently at a single frequency. In one prior art approach, operation at two different frequencies has been accomplished manually, by switching the spectrometer power off (or at least putting the machine into some sort of stand-by mode), mechanically dismounting the quad driver or the LC resonant circuit assembly and replacing it with a different quad driver or LC resonant circuit assembly that operates at a different frequency, and then powering the spectrometer back up.

### OVERVIEW

Described herein is an economical and elegant arrangement to quickly switch between two or more different operating frequencies of a mass spectrometer, allowing either sensitivity or resolution to be selectively maximized while minimizing the power requirement for high-sensitivity operation. In certain embodiments, the data from the two operating modes can be combined in some cases to provide both high resolution and high sensitivity in a given experiment.

In certain embodiments, the frequency switching is accomplished by simultaneously switching the oscillator frequency (the drive frequency to the RF power amplifier) and changing the inductance of the resonator coils in the step-up circuit so the LC resonator network resonates at the new drive frequency. The coil inductances are changed by using switches to short out a portion of the coil windings or, alternatively to select taps on the coil windings. The switches may be PIN diode switches, PN diodes, mechanical relays, MOSFETs, or other suitable devices.

In certain embodiments the frequency switching is accomplished by simultaneously switching the oscillator frequency (the drive frequency to the RF power amplifier) and changing the capacitive load in the LC resonant step-up circuit so it resonates at the new frequency. The capacitive load is changed by using switches to connect additional capacitance across the capacitive load formed by the rod sets. The switches may be relays, PIN diodes, PN diodes, MOSFETs, bipolar transistors, or other suitable devices.

Also described herein is a system that includes a mass analyzer, an ion source for providing ions to the mass analyzer, a detector for detecting an output of the mass analyzer, and a frequency-selectable power source. The frequency-selectable power source may include an energy supply configured to provide high-voltage radio-frequency (RF) energy to the mass analyzer at individually selectable first and second or more frequencies, and a frequency selector for switching between the individually selectable first and second or more frequencies.

Also described herein is a method for changing a frequency of high-voltage radio-frequency (RF) energy provided by an energy supply to a mass analyzer of a mass spectrometer. The method includes changing a frequency of an oscillating signal provided to a power amplifier of the energy supply from a first frequency to a second frequency, and using a switch to tune, from the first frequency to the second frequency, a step-up LC resonator circuit that is operable to magnify an output of the power amplifier.

In any embodiment described herein, the ion source may be an electron impact (EI) source, an electrospray ionization (ESI) source, a chemical ionization (CI) source, a photoionization (PI) source, a matrix assisted laser desorption/ionization (MALDI) source, an inductively coupled plasma (ICP) source, a multi-mode source (such as a combination of ESI and CI), or any other ion source for mass spectrometers. In addition, while described specifically with resepect to a mass analyzer, the arrangements described herein are more generally applicable to ion guides, and to for example time-of-flight (TOF) analyzers, particularly those with a multi-pole.

### BRIEF DESCRIPTION OF THE DRAWINGS

The accompanying drawings, which are incorporated into and constitute a part of this specification, illustrate one or more examples of embodiments and, together with the description of example embodiments, serve to explain the principles and implementations of the embodiments.

In the drawings:
FIG. 1 is a block diagram of a mass spectrometry system in accordance with certain embodiments;
FIG. 2A is a more detailed view of frequency-selectable power source in accordance with certain embodiments;
FIG. 2B shows an arrangement in which coil inductance can be changed by by selecting different taps on a coil winding;
FIG. 3A shows a series resonant circuit implemented as the energy supply;
FIG. 3B shows an arrangement in which coil inductance can be changed by selecting different taps on a coil winding;
FIGS. 4A and 4B are a schematic diagrams of implementations of switches as relays;
FIGS. 5A and 5B are a schematic diagrams of implementations of switches as PIN diodes;
FIG. 6 is a schematic diagram of an implementation of switches as a MOSFET; and
FIGS. 7A and 7B are schematic diagrams showing implementations of relays used to change the total load capacitance from each rod set to ground or from rod set to rod set.

### DESCRIPTION OF EXAMPLE EMBODIMENTS

The following description is illustrative only and is not intended to be in any way limiting. Other embodiments will readily suggest themselves to those of ordinary skill in the art having the benefit of this disclosure. Reference will be made in detail to implementations of the example embodiments as illustrated in the accompanying drawings. The same reference indicators will be used to the extent possible throughout the drawings and the following description to refer to the same or like items.

In the description of example embodiments that follows, references to "one embodiment", "an embodiment", "an example embodiment", "certain embodiments," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described.

In the interest of clarity, not all of the routine features of the implementations described herein are shown and described. It will be appreciated that in the development of any such actual implementation, numerous implementation-specific decisions must be made in order to achieve the developer's specific goals, such as compliance with application- and business-related constraints, and that these specific goals will vary from one implementation to another and from one developer to another. Moreover, it will be appreciated that such a development effort might be complex and time-consuming, but would nevertheless be a routine undertaking of engineering for those of ordinary skill in the art having the benefit of this disclosure.

The term "exemplary" when used herein means "serving as an example, instance or illustration." Any embodiment described herein as "exemplary" is not necessarily to be construed as preferred or advantageous over other embodiments.

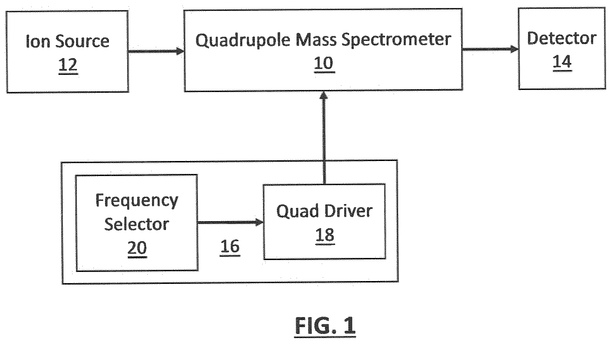

A mass spectrometry system in accordance with certain embodiments is shown in FIG. 1. A mass analyzer 10, such as a quadrupole mass analyzer, is coupled to an ion source 12 and a detector 14. A frequency-selectable power source 16 drives a multi-rod assembly (not shown) of the mass analyzer 10. The frequency-selectable power source 16 includes a high-voltage radio-frequency (RF) energy supply 18, which, in the case of a four-rod assembly, may be referred to as a quad driver. Frequency-selectable power source 16 also includes a frequency selector 20 to select the frequency of high-voltage RF energy supply 18.

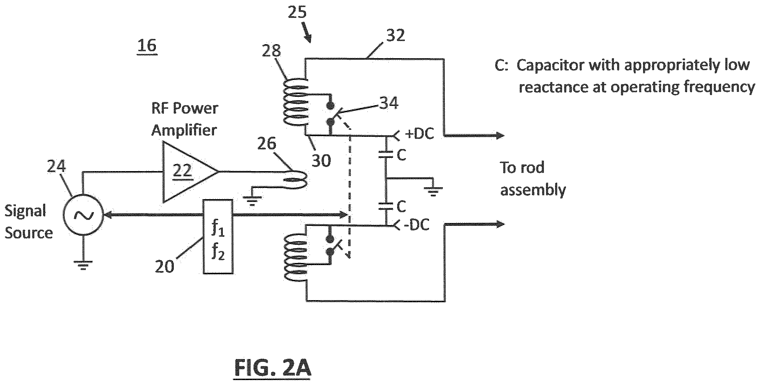

FIG. 2A is a more detailed view of frequency-selectable power source 16 in accordance with certain embodiments. The power source 16 is generally configured as an LC (inductor-capacitor) circuit for outputting RF power to the mass mass analyzer 10 (FIG. 1) at one of multiple selectable frequencies, in this example case two. It operates by stepping up an output voltage of an RF power amplifier 22, whose input is fed a signal from an oscillator or frequency synthesizer 24 operating at a selectable resonant frequency of an LC step-up network 25 formed by an inductor 28 and the capacitance of the rod assembly plus any added capacitance. Capacitors C provide a suitably low-impedance path to ground at both operating frequencies.

In the arrangement of FIG. 2A, the energy supply (signal source 24, RF power amplifier 22, and LC step-up network 25, plus associated control circuitry) is configured as employing a parallel resonant circuit that uses an additional small winding 26 added to the resonator inductor 28, resulting in a step-up transformer. The RF power amplifier 22 drives the added winding 26. The coil winding of resonator inductor 28 has one end 30 AC-grounded, with the high-voltage output to the rod assembly of the mass analyzer 10 being taken from the other end 32. The voltage magnification is achieved through *transformation* (transformer action), with the step-up ratio approximating the turns ratio of the two windings of resonant inductor 28.

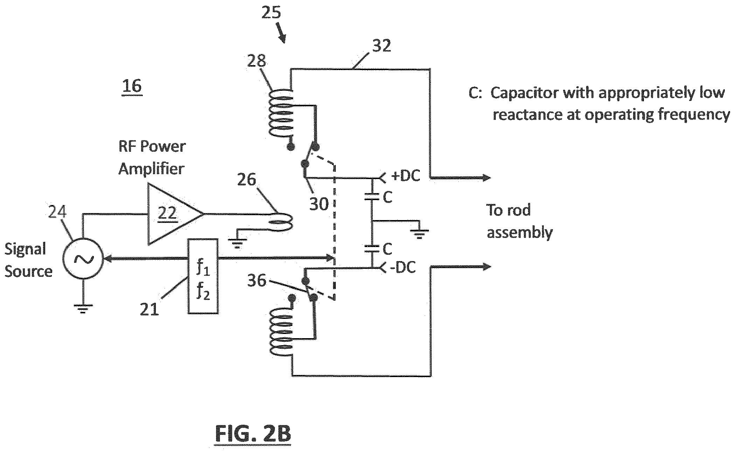

The circuit of FIG. 2A is inherently narrow-band at the selected operating frequency since it is based upon a high-Q (low loss) resonant circuit. However, the operating frequency can be selectively changed between two individually selectable values *f*₁ and *f*₂ by frequency selector 20. In particular, frequency selector 20 switches the drive frequency of oscillator 24 to one of the two frequencies *f*₁ and *f*₂*,* and at the same time changes the coil inductance of resonant inductor 28, and, commensurately, the resonance frequency of the LC circuit, to match it to the new drive frequency. An operator can for example use frequency selector 20 to select the higher of the two frequencies *f*₁ and *f*₂ to drive the mass analyzer 10 to achieve greater resolution, or can select the lower of the two frequencies *f*₁ and *f*₂ to achieve increased sensitivity at the same RF power level. The changes between the frequencies *f*₁ and *f*₂ can be performed consecutively, to provide first a greater resolution run and then an increased sensitivity run of the same sample. This order can of course be reversed. Frequency selector 20 changes the coil inductance of resonant inductor 28 by actuating switch 34, which operates to short out a portion of the inductor coil windings. Alternatively, as shown in FIG. 2B, coil inductance can be changed by frequency selector 21 by selecting different taps on the coil winding using switch 36.

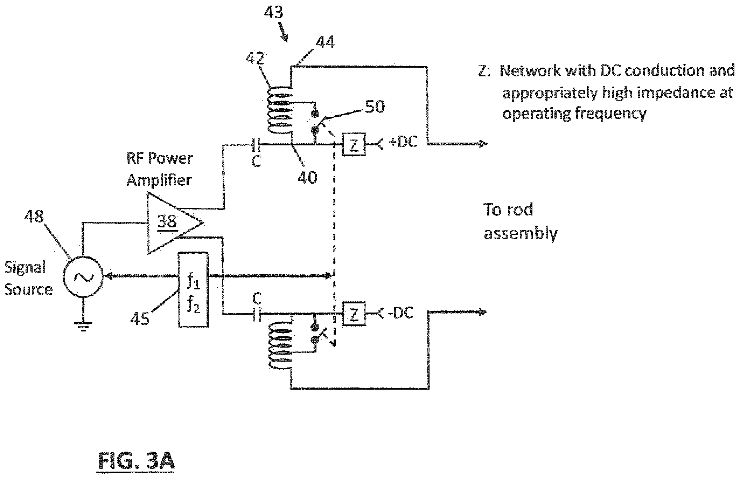

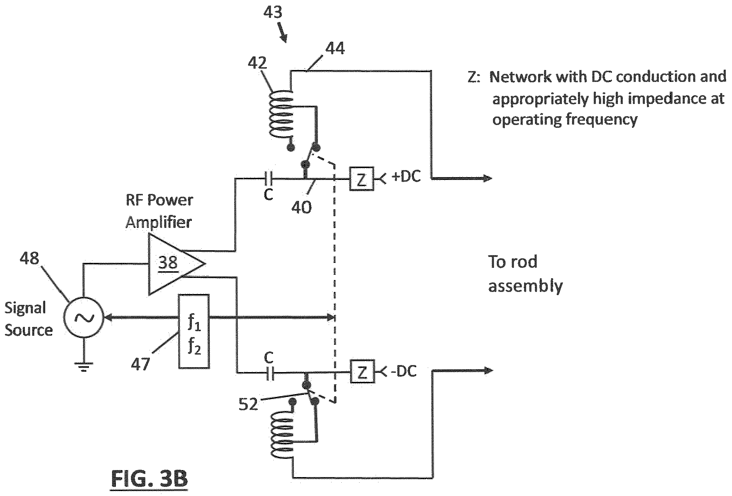

In certain embodiments, a series resonant circuit can be implemented as the energy supply (signal source, RF power amplifier with differential outputs, and LC step-up network, plus associated control circuitry), as shown schematically in FIG. 3A. RF power amplifier 38 with differential outputs, which approximates a voltage source (very low output resistance at each of its outputs), directly drives the base 40 of the resonator inductor 42 of LC step-up network 43. The high-voltage output to the rod assembly of the mass spectrometer is then taken from the other end 44 of the inductor. Z represents a network with DC conduction and appropriately high impedance at the operating frequency. The voltage magnification is achieved entirely through *resonant rise* (at resonance the phase shift across the inductor is 90 degrees, or a quarter wave, corresponding to a voltage minima at the drive end and a voltage maxima at the other end). The voltage step-up ratio is equal to the circuit Q (quality factor). The Q factor in this case includes the effects of all circuit losses, including those contributed by the load. Frequency selector 45 can be used to change the operating frequency between two individually selectable values *f*₁ and *f*₂ by changing the drive frequency of oscillator 48 to one of the two frequencies *f*₁ and *f*₂, and at the same time changing the coil inductance of resonant inductor 42, and, commensurately, the resonance frequency of the LC circuit of network 43 to match it to the new drive frequency. An operator can for example use frequency selector 45 to select the higher of the two frequencies *f*₁ and *f*₂ to drive the mass spectrometer to achieve greater resolution, or can select the lower of the two frequencies *f*₁ and *f*₂ to achieve increased sensitivity at the same RF power level. The changes between the frequencies *f*₁ and *f*₂ can be performed consecutively, to provide first a greater resolution run and then an increased sensitivity run of the same sample. This order can of course be reversed. The coil inductance of resonant inductor 42 can be changed by selector 45 using a switch 50, which operates to short out a portion of the coil windings. Alternatively, as shown in FIG. 3B, it can be changed by selector 47 to select different taps on the coil winding using switch 52.

The parallel or series resonator approaches described above have the advantage of allowing the capacitance of the load (the multi-polar rod assembly) to be *resonated out* by having its rod-set-to-rod-set capacitance comprise the majority of the over-all circuit capacitance resonating with the inductance of the resonator. The use of resonance reduces significantly the required power from the amplifier (typically by one to two orders of magnitude). The arrangements described above provide economical and fast (< 10 milliseconds) provisions for changing the operating frequency without changing out assemblies or switching off the power as in the prior art. Some advantages compared to single, set frequency prior art devices include low cost, ease of switching, no increase in size, no mechanical swapping of of assemblies, no instrument powering off requirement, fast, automated switching speed, and the ability to automatically integrate data from multiple frequency runs to show both high resolution (high frequency operation) and high sensitivity (low frequency operation) across appropriate ranges of the AMU span on a single graph.

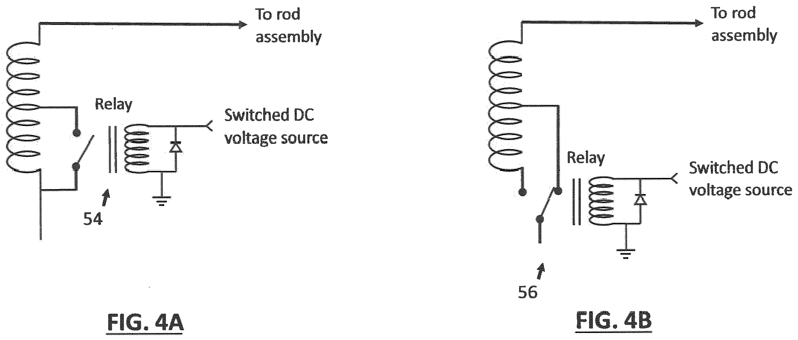

FIG. 4A is a schematic diagram of implementations of switches 34 and 50 discussed above. In particular, in the arrangement of FIG. 4A, an RF vacuum relay 54 corresponding to switch 34 (FIG. 2A) or switch 50 (FIG. 3A) is used to perform the switching by effectively connecting different lengths of the resonator coil. RF vacuum relay 54 is controlled by a switched DC voltage source provided by the frequency selector 20 (FIG. 2A) or frequency selector 45 (FIG. 3A). For illustrative simplicity only one coil of the resonator is shown and the connections to the bottom end of the coil are not detailed (except for the relay connections). Of course non-vacuum relays may be used, but they have disadvantages regarding physical size and lifetime.

FIG. 4B is a schematic diagram of implementations of switches 36 and 52 discussed above. In particular, in the arrangement of FIG. 4B, an RF vacuum relay 56 corresponding to switch 36 (FIG. 2B) or switch 52 (FIG. 3B) is used to perform the switching by effectively connecting different lengths of the resonator coil. RF vacuum relay 56 is controlled by a switched DC voltage source provided by the frequency selector 45 (FIG. 2B) or frequency selector 47 (FIG. 3B). For illustrative simplicity only one coil of the resonator is shown and the connections to the bottom end of the coil are not detailed (except for the relay connections). As in above, non-vacuum relays may be used, but they have disadvantages regarding physical size and lifetime.

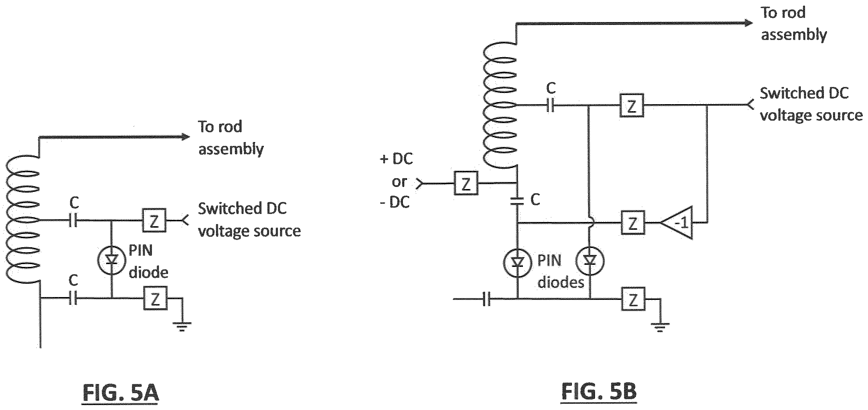

In certain embodiments, switching can be performed using PIN diodes, as seen in FIGS. 5A and 5B. For illustrative simplicity only one coil is shown and the connections to the bottom of the coil are not detailed (except for the connections relating to the PIN diodes). FIG. 5A is applicable to the FIG. 2A and FIG. 3A topologies, while FIG. 5B is applicable to the FIG. 2B and FIG. 3B topologies. Those of ordinary skill in the art will understand the requirements for the diode voltage rating, current rating, and carrier lifetime, as well as the required control voltage range. The circuits of FIGS. 5A and 5B use capacitors with appropriately low reactance at operating frequency, and the networks Z are networks with DC conduction and appropriately high impedance at the operating frequency. The PIN diodes can be replaced with PN diodes if sufficient bias current is applied to ensure that the diode states are not affected by RF current flow.

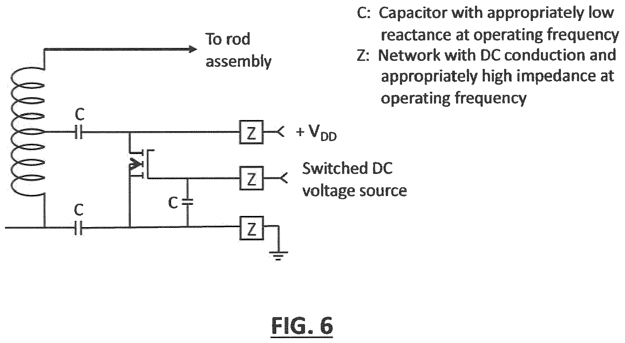

In certain embodiments, switching can be performed using MOSFETs, as seen in FIG. 6. Although directed to the FIG. 2A topology, it can be readily extended to the FIG. 3A topology by those of ordinary skill in the art.

Topologies using other devices such as bipolar junction transistors (BJTs) or insulated gate bipolar junction transistors (IGBJTs) are also possible, such as (for example) connecting the devices in anti-parallel pairs so conduction can occur in both directions. Alternatively, sufficient bias current could be employed to cover RF conduction in either direction. Furthermore, although all of the described embodiments are for topologies that switch between two different frequencies, those skilled in the art will appreciate that the same general techniques described may be used to switch between any number of different frequencies.

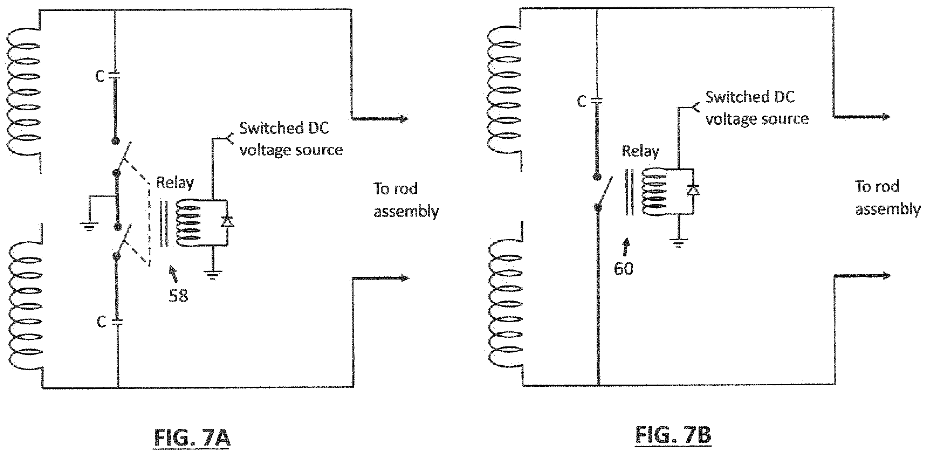

FIGS. 7A and 7B are directed to topologies in which resonance is changed by changing capacitance in the LC circuit, rather than changing inductance. In FIG. 7A, the frequency selector (not shown) actuates a switch in the form of a relay 58 to change the total load capacitance from each rod set to ground. In FIG. 7B, the frequency selector (not shown) actuates a switch in the form of a relay 60 to change capacitance from rod set to rod set.

### Exemplary Embodiments

In addition to the embodiments described elsewhere in this disclosure, exemplary embodiments of the present invention include, without being limited to, the following:
1. A system comprising:
   a mass analyzer;
   an ion source for providing ions to the mass analyzer;
   a detector coupled to the mass analyzer for detecting ions; and
   a frequency-selectable power source including:
      an energy supply configured to provide high-voltage radio-frequency (RF) energy to the mass analyzer at individually selectable first and second frequencies, and
      a frequency selector for switching between the individually selectable first and second frequencies.
2. The system of embodiment 1, wherein the energy supply comprises:
   a power amplifier having an output;
   a signal source for providing an oscillating signal to the power amplifier; and
   a step-up circuit for magnifying the power amplifier output, the step-up circuit including an LC resonator network tunable to the oscillating signal frequency,
   and wherein the frequency selector is configured to set the oscillating signal frequency to one of the two individually selectable first and second frequencies, and includes a switch for tuning the LC resonator network to the set oscillating signal frequency.
3. The system of embodiment 2, wherein the LC resonator network includes a resonator having coil windings and a coil inductance, and wherein the switch is configured to change said coil inductance.
4. The system of embodiment 3, wherein the switch is operable to short out a portion of the coil windings.
5. The system of embodiment 3, wherein the switch is operable to select different taps of the coil windings.
6. The system of any of embodiments 2-5, wherein the switch comprises a relay.
7. The system of any of embodiments 2-5, wherein the switch comprises a vacuum relay.
8. The system of any of embodiments 2-5, wherein the switch comprises a PIN diode.
9. The system of any of embodiments 2-5, wherein the switch comprises a PN diode.
10. The system of any of embodiments 2-5, wherein the switch comprises a MOSFET.
11. The system of any of embodiments 1-10, wherein the energy supply is configured as a parallel resonant circuit.
12. The system of any of embodiments 1-10, wherein the energy supply is configured as a series resonant circuit.
13. The system of any of embodiments 1-2, wherein the switch is configured to change the capacitance of the LC resonator network.
14. A method for changing a frequency of high-voltage radio-frequency (RF) energy provided by an energy supply to a mass analyzer of a mass spectrometer, comprising:
   changing a frequency of an oscillating signal provided to a power amplifier of the energy supply from a first frequency to a second frequency; and
   using a switch to tune, from the first frequency to the second frequency, a step-up LC resonator circuit that is operable to magnify an output of the power amplifier.
15. The method of embodiment 14, wherein the step-up LC resonator circuit includes a resonator having coil windings and a coil inductance, and wherein said tuning comprises changing said coil inductance.
16. The method of embodiment 15, wherein changing said coil inductance comprises shorting out a portion of the coil windings.
17. The method of embodiment 15, wherein changing said coil inductance comprises selecting different taps of the coil windings.
18. The method of any of embodiments 14-17, wherein the switch comprises a vacuum relay.
19. The method of any of embodiments 14-17, wherein the switch comprises a PIN diode.
20. The method of any of embodiments 14-19, wherein the energy supply is configured as a parallel resonant circuit.
21. The method of any of embodiments 14-19, wherein the energy supply is configured as a series resonant circuit.
22. The method of any of embodiments 14-15, wherein said tuning comprises changing the capacitance of the LC resonator circuit.
23. The system or method of any one of the preceding embodiments, wherein the mass analyzer is a quadrupole mass analyzer.
24. The system or method of any one of the preceding embodiments, wherein the mass analyzer is an ion guide.
25. The system or method of any one of the preceding embodiments, wherein the mass analyzer is time-of-flight (TOF) analyzer.

While embodiments and applications have been shown and described, it would be apparent to those skilled in the art having the benefit of this disclosure that many more modifications than mentioned above are possible without departing from the inventive concepts disclosed herein. The invention, therefore, is not to be restricted based on the foregoing description.

## Claims

1. A system comprising:
a mass analyzer;
an ion source for providing ions to the mass analyzer;
a detector coupled to the mass analyzer for detecting ions; and
a frequency-selectable power source including:
an energy supply configured to provide high-voltage radio-frequency (RF) energy to the mass analyzer at individually selectable first and second frequencies, and
a frequency selector for switching between the individually selectable first and second frequencies.

2. The system of claim 1, wherein the energy supply comprises:
a power amplifier having an output;
a signal source for providing an oscillating signal to the power amplifier; and
a step-up circuit for magnifying the power amplifier output, the step-up circuit including an LC resonator network tunable to the oscillating signal frequency,
and wherein the frequency selector is configured to set the oscillating signal frequency to one of the two individually selectable first and second frequencies, and includes a switch for tuning the LC resonator network to the set oscillating signal frequency.

3. The system of claim 2, wherein the LC resonator network includes a resonator having coil windings and a coil inductance, and wherein the switch is configured to change said coil inductance.

4. The system of claims 1-3, wherein the switch comprises a vacuum relay.

5. The system of claims 1-3, wherein the switch comprises a PIN diode.

6. The system of claims 1-3, wherein the switch comprises a PN diode.

7. The system of claims 1-2, wherein the switch is configured to change the capacitance of the LC resonator network.

8. The system of claim 1-7, wherein the energy supply is configured as a parallel resonant circuit.

9. The system of claim 1-7, wherein the energy supply is configured as a series resonant circuit.

10. A method for changing a frequency of high-voltage radio-frequency (RF) energy provided by an energy supply to a mass analyzer of a mass spectrometer, comprising:
changing a frequency of an oscillating signal provided to a power amplifier of the energy supply from a first frequency to a second frequency; and
using a switch to tune, from the first frequency to the second frequency, a step-up LC resonator circuit that is operable to magnify an output of the power amplifier.

11. The method of claim 10, wherein the step-up LC resonator circuit includes a resonator having coil windings and a coil inductance, and wherein said tuning comprises changing said coil inductance.

12. The method of claims 10-11, wherein the switch comprises a vacuum relay.

13. The method of claims 10-12, wherein said tunning comprises changing the capacitance of the LC resonator circuit.

14. The method of claims 10-13, wherein the energy supply is configured as a parallel resonant circuit.

15. The method of claims 10-13, wherein the energy supply is configured as a series resonant circuit.
